# FASCICULE DE BREVET EUROPEEN

(11) **EP 2 795 677 B1**
(45) Date de publication et mention de la délivrance du brevet: **06.05.2020**
(21) Numéro de dépôt: 12808817.6
(22) Date de dépôt: 20.12.2012
(51) Int. Cl.: H01L 31/0236

(54) **PROCEDE DE TEXTURATION DE LA SURFACE D'UN SUBSTRAT DE SILICIUM, SUBSTRAT STRUCTURE ET DISPOSITIF PHOTOVOLTAÏQUE COMPORTANT UN TEL SUBSTRAT STRUCTURE**
VERFAHREN ZUR TEXTURIERUNG DER OBERFLÄCHE EINES SILICIUMSUBSTRATS, STRUKTURIERTES SUBSTRAT UND FOTOVOLTAIKMODUL MIT SOLCH EINEM STRUKTURIERTEN SUBSTRAT
PROCESS FOR TEXTURING THE SURFACE OF A SILICON SUBSTRATE, STRUCTURED SUBSTRATE AND PHOTOVOLTAIC DEVICE COMPRISING SUCH A STRUCTURED SUBSTRATE

(30) Priorité: 22.12.2011 FR 1104038
(43) Date de publication de la demande: 29.10.2014
(73) Titulaire: Total Marketing Services, 92800 Puteaux (FR); Centre National de la Recherche Scientifique (C.N.R.S.), 75016 Paris (FR); Ecole Polytechnique, 91120 Palaiseau (FR)
(72) Inventeur: HABKA, Nada, 75014 Paris (FR); BULKIN, Pavel, 91140 Villebon Sur Yvette (FR); ROCA i CABARROCAS, Pere, 91140 Villebon Sur Yvette (FR)
(74) Mandataire: Croonenbroek, Thomas Jakob
(86) Numéro de dépôt international: PCT/EP2012/076338
(87) Numéro de publication internationale: WO 2013/092833

(56) Documents cités:
- WO-A1-2010/105703
- WO-A2-2011/023894
- US-A1- 2011 151 610
- YOO J ET AL: "Black surface structures for crystalline silicon solar cells", MATERIALS SCIENCE AND ENGINEERING B, ELSEVIER SEQUOIA, LAUSANNE, CH, vol. 159-160, 15 mars 2009 (2009-03-15), pages 333-337, XP026109149, ISSN: 0921-5107, DOI: 10.1016/J.MSEB.2008.10.019 [extrait le 2009-03-15]
- YOO J ET AL: "RIE texturing optimization for thin c-Si solar cells in SF6/O2 plasma", JOURNAL OF PHYSICS D. APPLIED PHYSICS, IOP PUBLISHING, BRISTOL, GB, vol. 41, no. 12, 21 juin 2008 (2008-06-21) , page 125205, XP020133363, ISSN: 0022-3727
- VAN DEN OEVER P J ET AL: "Plasma properties of a novel commercial plasma source for high-throughput processing of c-Si solar cells", CONFERENCE RECORD OF THE THIRTY-FIRST IEEE PHOTOVOLTAIC SPECIALIST CONFERENCE (IEEE CAT. NO. 05CH37608) IEEE PISCATAWAY, NJ, USA,, 3 janvier 2005 (2005-01-03), pages 1320-1323, XP010823000, DOI: 10.1109/PVSC.2005.1488384 ISBN: 978-0-7803-8707-2
- J. JOURDAN ET AL: "IMPROVED MULTICRYSTALLINE SILICON WAFER TEXTURISATION BY PLASMA ETCHING", 26TH EUROPEAN PHOTOVOLTAIC SOLAR ENERGY CONFERENCE, HAMBURG, 9 septembre 2011 (2011-09-09), pages 1774-1778, XP055042548,
- LEVCHENKO I ET AL: "Silicon on silicon: self-organized nanotip arrays formed in reactive Ar+H2 plasmas; Silicon on silicon: self-organized nanotip arrays formed in reactive Ar+ H2 plasmas", NANOTECHNOLOGY, IOP, BRISTOL, GB, vol. 21, no. 2, 15 January 2010 (2010-01-15), page 25605, XP020168737, ISSN: 0957-4484

## Description

La présente invention est relative à un procédé de texturation de la surface d'un substrat de silicium, un substrat structuré et un dispositif photovoltaïque comportant un tel substrat texturé.

Dans la fabrication notamment de cellules photovoltaïques, la texturation des substrats est largement utilisée pour réduire la réflectivité lumineuse à la surface de la cellule et pour améliorer le piégeage de la lumière afin d'augmenter le rendement des cellules photovoltaïques.

La texturation consiste à former par divers procédés des structures à l'échelle nanométrique et/ou micrométrique à la surface du silicium.

Les structures formées connues sont le plus souvent des pyramides micrométriques ou des nanofils et des nanocônes.

Certes, ces structures permettent de baisser la réflectivité en surface des cellules photovoltaïques, mais posent aussi un certain nombre de problèmes lorsqu'on dépose d'autres couches de silicium dessus.

De plus, les méthodes actuellement connues sont assez chères et posent, notamment pour la gravure par voie humide des problèmes environnementaux.

Le document " Martin A Green, Jianhua Zhao, Aihua Wang and Stuart R Wenham, IEE Transactions on Electronic Devices, Vol. 46, No. 10, pp. 1940 - 1947 (1999) " décrit par exemple un procédé de photolithographie et de gravure par voie humide permettant d'obtenir un substrat de silicium c-Si (100) avec des structures en forme de pyramides inversées sur sa surface.

Cependant, malgré une baisse appréciable de la réflectivité, ce procédé est long, onéreux, et polluant car il nécessite l'utilisation de grandes quantités d'eau déionisée, et de solutions chimiques telles que des solutions de KOH ou de NaOH, qu'il faut traiter de manière adaptée pour répondre aux normes environnementales.
Une autre méthode connue est par exemple exposée dans le document "J Yoo, Kyunghae Kim, M. Thamilselvan, N. Lakshminarayan, Young Kuk Kim, Jaehyeong Lee, Kwon Jong Yoo and Junsin Yi, Journal of Physics D: Applied Physics, Vol. 41, pp. 125205 (2008) " ou dans le Brevet Français du 24 août 2009 n° de dépôt 09 55767 PCT/FR2010/051756 «Procédé de texturation de la surface d'un substrat de silicium et substrat de silicium texturé pour cellule solaire ». Il s'agit d'une méthode de gravure par voie sèche utilisant un plasma de SF6/O2 pour texturer la surface d'un substrat de silicium cristallin c-Si (100).

Malgré l'obtention d'une texturation d'une multitude de structures en forme d'aiguille ou de pyramides à la surface du substrat de silicium et une baisse de la réflectivité, la surface est telle qu'un dépôt conforme avec une bonne passivation d'une autre couche de silicium devient difficile, voire impossible.

De plus, le SF₆ a également un fort impact environnemental, notamment au niveau de l'effet de serre.

Une autre méthode est exposée dans le document "I Levchenko, S Y Huang, K Ostrikov and S Xu, Nanotechnology (IOP Publishing), Vol 21, no. 2, page 25605 (2010)". Il s'agit d'une méthode de texturisation de la surface d'un substrat de silicium cristallin utilisant un plasma d'Ar ou d'un mélange d'Ar et H₂. Ainsi, l'invention vise à pallier au moins partiellement les divers inconvénients cités ci-dessus.

A cet effet, l'invention a pour objet de fournir un procédé de texturation permettant d'obtenir un substrat de silicium ayant une faible réflectivité, avec une surface texturée qui peut être utilisée pour la fabrication de cellules solaires.

Ainsi, l'invention concerne un procédé de texturation de la surface d'un substrat de silicium comprenant une phase d'exposition de la dite surface à un plasma d'Ar ou d'un mélange d'Ar et de H₂ de haute densité, caractérisé en ce que la température est inférieure à 200°C, la puissance est comprise entre 1.5 W/cm² et 6.5 W/cm², le flux d'argon est supérieur à trois fois le flux d'hydrogène, la polarisation du substrat est comprise entre 100 V et 300V, et la pression de travail est entre 0,7 Pascal et 1,3 Pascal.

Selon d'autres caractéristiques prises seules ou en combinaison :
Selon une première variante, le plasma est un plasma haute densité de type résonance cyclotronique électronique distribuée en matrice (MDECR).

Selon une seconde variante, le plasma est un plasma haute densité généré par couplage inductif (ICP).

Selon une troisième variante, le plasma haute densité est un plasma par couplage inductif résonant, également dénommé plasma Helicon.

Selon une quatrième variante, le plasma est un plasma thermique expansif ETP.

Selon un premier aspect pour un plasma d'un mélange d'Ar et de H₂, le flux d'argon est supérieur à trois fois le flux d'hydrogène.

Selon un deuxième aspect, la pression de travail pendant la phase d'exposition est de 0,7 Pascal.

Selon un troisième aspect, le temps d'exposition de la surface au plasma d'Ar ou d'un mélange d'Ar et de H₂ de haute densité est supérieur à 1 minute, notamment compris entre 1 et 30 minutes.

Par ailleurs, on peut prévoir qu'avant ladite étape d'exposition au plasma d'Ar ou d'un mélange d'Ar et de H₂ de haute densité, on réalise une étape de texturation permettant d'obtenir des pyramides micrométriques.

Selon un autre aspect, le substrat de silicium est du silicium cristallin, notamment orienté 100 ou 111, à l'état poli, gravé ou brut de sciage.

L'invention concerne également un substrat de silicium structuré, caractérisé en ce qu'il comprend une surface texturée comprenant des structures en plans enroulés.

Selon une première variante, les structures en plan enroulées sont des structures en plans enroulés unitaires.

Selon une seconde variante, la surface texturée comprend des structures combinées en pyramides avec les plans enroulés.

On règle l'exposition au plasma haute densité de sorte que le plan enroulé présente environ 200nm de hauteur et 20 nm d'épaisseur.

Selon un autre aspect, le diamètre moyen extérieur des structures enroulées unitaires est compris entre 150nm et 250nm.

Selon encore un autre aspect, le diamètre extérieur et la hauteur moyens de la structure binaire est équivalent à ceux des pyramides.

Le substrat de silicium de base est par exemple du silicium cristallin, notamment orienté 100 ou 111, à l'état poli, gravé ou brut de sciage.

Le substrat de silicium structuré tel que défini ci-dessus est notamment obtenu par le procédé tel que défini ci-dessus.

L'invention concerne aussi un dispositif photovoltaïque, caractérisé en ce qu'il comprend un substrat structuré avec une surface texturée tel que défini ci-dessus.

Selon un mode de réalisation, il s'agit d'un dispositif photovoltaïque en couches minces.

Selon un autre mode de réalisation, il s'agit d'un dispositif photovoltaïque en silicium mono - cristallin, notamment un dispositif photovoltaïque à hétérojonctions

D'autres avantages et caractéristiques apparaîtront à la lecture de la description des figures suivantes, parmi lesquelles :
- la figure 1 montre une image obtenue par un microscope électronique à balayage des structures unitaires obtenues sur un substrat de silicium,
- la figure 2 montre une vue agrandie de la figure 1,
- la figure 3 montre une image obtenue par un microscope électronique à balayage des structures binaires obtenues sur un substrat de silicium déjà gravé avec des pyramides micrométriques,
- la figure 4 montre une vue agrandi de la figure 3,
- la figure 5 montre un spectre de la réflectivité en fonction de la longueur d'onde d'une part d'une surface de substrat de silicium polie sans texturation et d'autre part de deux substrats texturés unitaires et binaires selon l'invention.

L'invention concerne un procédé de texturation de la surface d'un substrat de silicium comprenant une phase d'exposition de ladite surface à un plasma d'Ar (argon) ou d'un mélange d'Ar et de H₂ à une température inférieure a 200°C, le plasma étant de haute densité d'une puissance comprise entre 1.5 W/cm² et 6.5 W/cm², où la tension de polarisation, obtenue en appliquant une tension RF au porte-substrat, est comprise entre 100V et 300V, le flux d'argon est supérieur à trois fois le flux d'hydrogène, et la pression de travail est entre 0,7 Pascal et 1,3 Pascal.

Un tel plasma haute densité peut être généré de différentes façons par exemple par MDECR (pour « Matrix Distributed Electron Cyclotron Résonance » ou «Multi Dipolar Electron Cyclotron Resonance), ICP (pour « inductive coupled plasma » en anglais, c'est-à-dire un plasma à couplage inductif) ou ETP (pour « expanding thermal plasma » en anglais, c'est-à-dire un plasma thermique expansif).

Selon une première variante, le plasma d'Ar ou d'un mélange d'Ar et de H₂ haute densité peut donc être un plasma MDECR réalisé par un réacteur MDECR (pour « Matrix Distributed Electron Cyclotron Resonance » ou «Multi Dipolar Electron Cyclotron Resonance) qui est bien connu en soi dans la technique et ne sera pas décrit dans le détail.

Pour un exemple de réalisation d'un réacteur MDECR, on peut se référer en particulier à la thèse de Monsieur Laurent KROELY « Process and material challenges in high rate deposition of microcrystalline silicon thin films and solar cells by Matrix Dristributed Electron Cyclotron Resonance Plasma » soutenue le 28/9/2010 à l'Ecole Polytechnique en France, en particulier au réacteur MDECR du type ATOS décrit à partir de la page 68 de cette thèse et qui a été utilisé pour la réalisation du procédé et les substrats selon l'invention, ou encore au document FR 2 838 020 décrivant un tel réacteur.

Dans ces réacteurs, on réalise un confinement multipolaire des électrons formant le plasma.

Selon une seconde variante, le plasma d'Ar ou d'un mélange d'Ar et de H₂ haute densité peut être un plasma à couplage inductif ICP ou à couplage inductif résonant (plasma Hélicon). Un générateur de plasma ICP adapté pour ce faire est par exemple décrit dans le document US2010/0083902. Dans un tel générateur, l'énergie est fournie par des courants électriques qui sont produits par induction magnétique, c'est à dire des champs magnétiques variant dans le temps.

Selon une troisième variante, le plasma d'Ar ou d'un mélange d'Ar et de H₂ haute densité peut être un plasma ETP. Un générateur pour ce faire est par exemple décrit dans le document EP 2 261 392. Dans un plasma ETP, on génère un plasma avec une source d'arc en cascade.

Dans le présent cas, le plasma est un plasma haute densité d'argon soit tout seul, soit c'est un mélange d'hydrogène (H₂) et d'argon (Ar). Dans ce cas, le flux d'hydrogène est inférieur au flux d'argon, de préférence avec un rapport de manière que le flux d'argon est supérieur à trois fois le flux d'hydrogène.

On a constaté que ce sont les ions d'argon qui sont à l'origine des structures de texturation observées et que l'hydrogène permet un effet d'homogénéisation sur l'ensemble de la surface texturée.

Pour ce plasma, la pression de travail est entre 0,7 Pascal et 1,3 Pascal.

Le temps d'exposition au plasma précité est supérieur à 1 minute, notamment compris entre 1 et 30 minutes. Plus la tension de polarisation est importante plus le taux de gravure est important et on peut diminuer la durée d'exposition.

Ainsi, avec une tension de polarisation de 100V, on obtient un taux de gravure de 12nm/min. Dans ce cas, on préconise une exposition d'au moins 30 minutes au plasma. Tandis qu'avec une tension de polarisation de 200V, un taux de gravure de 200nm/min peut être atteint avec de l'Ar pur, permettant de réduire le temps d'exposition à une durée comprise entre 1 et 20min.

Le substrat de silicium à texturer peut être du silicium cristallin, notamment orienté 100 ou 111, par exemple à l'état poli, gravé ou brut de sciage. En particulier il peut être ultra fin ou des films de silicium ultrafins (rigide ou flexible) avec une épaisseur pouvant varier de 5 à 50 µm.

Suivant la configuration initiale du substrat, on peut obtenir deux types de structures différentes appelés par la suite les structures unitaires et les structures binaires.

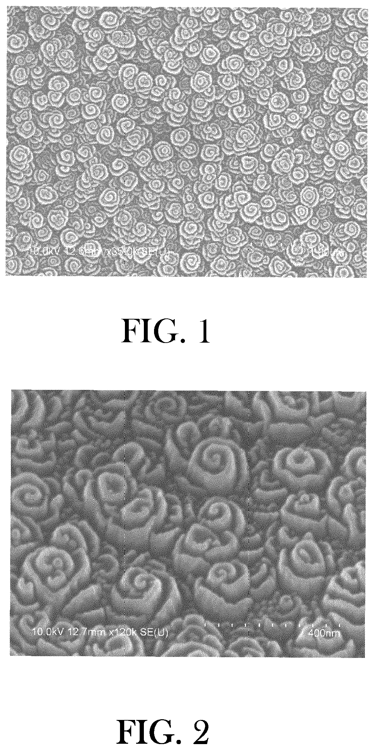

Les figures 1 et 2 montrent des images obtenues par un microscope à balayage électronique des structures de texturation produites sur la surface d'un substrat de Si poli ou brut de sciage.

On obtient une toute nouvelle texturation avec des structures en plans enroulés, notamment en spirale ou en forme de volute. Par plan enroulés, on entend des murets sensiblement verticaux séparés par des sillons et évoluant sur la surface du substrat de façon courbe. On peut même dire qu'il s'agit d'une forme de rose. C'est la structure unitaire, c'est-à-dire l'ensemble des plans enroulés autour d'un même centre.

La hauteur moyenne des structures unitaires (par exemple une « rose ») est d'environ 200nm et le diamètre moyen extérieur des structures unitaires est compris entre 150nm et 250nm. Par diamètre extérieur, on entend la distance diamétrale des surfaces externes d'une structure unitaire. L'épaisseur d'un plan enroulé est d'environ 20nm.

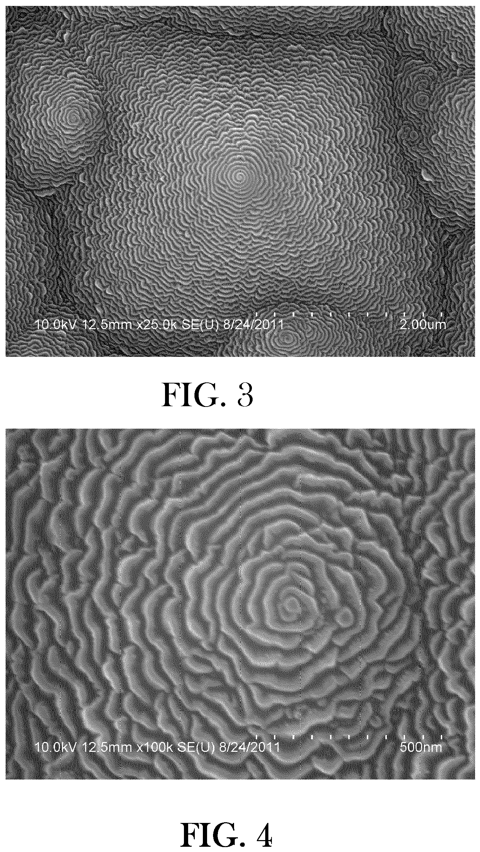

Les figures 3 et 4 montrent des images obtenues par un microscope à balayage électronique des structures de texturation produites sur la surface d'un substrat de Si préalablement gravé, par exemple pour obtenir des pyramides micrométriques.

On obtient une toute nouvelle texturation avec des structures en plans enroulés nanométriques qui se greffent sur le motif initial de gravure micrométrique (pyramide). C'est la structure binaire ou combinée.

Les dimensions des structures combinées sont équivalentes à celles des motifs initiaux de gravure.

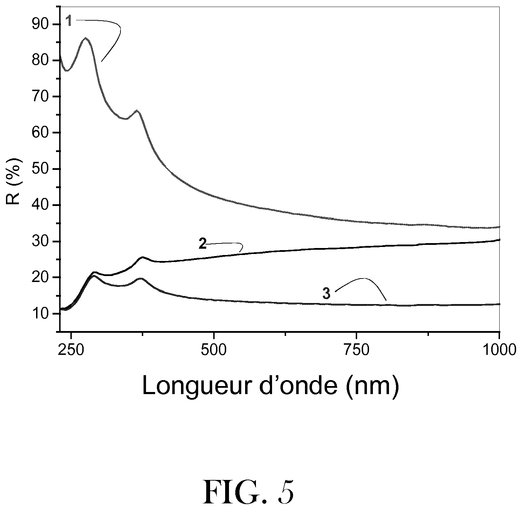

La figure 5 montre une première courbe 1 montrant la réflectivité en fonction de la longueur d'onde d'un substrat de silicium poli Fz(100) avant l'exposition à un plasma MDECR et une seconde courbe 2, montrant le même échantillon après l'exposition au plasma.

On constate une baisse significative de la réflectivité surtout dans la région du bleu (des faibles longueurs d'onde). Par rapport à une plaquette (« wafer » en anglais) polie, on observe une baisse de la réflectivité de 88,7% dans la région du bleu, c'est-à-dire les longueurs d'ondes inférieures à 500nm et de 56% dans la région du rouge, c'est-à-dire des longueurs d'ondes supérieures à 500nm.

Ainsi, l'absorption de la lumière est favorisée, notamment dans la région des rayons plus énergétiques, c'est-à-dire le bleu, et l'efficacité de conversion de la cellule peut être augmentée.

Le procédé tel que décrit ci-dessus est très avantageux, car il permet d'obtenir une nouvelle texturation pour réaliser du silicium noir (« black silicon » en anglais) dans des conditions environnementales beaucoup plus favorables.

En effet, par rapport au SF₆, qui est classiquement utilisé pour la texturation et qui possède un indice d'échauffement global de 22800 au niveau environnemental, l'impact de l'hydrogène avec un indice de 0 et de l'argon avec un indice 5,8 est négligeable.

De plus, il s'agit d'un procédé dit « basse température », typiquement inférieur à 200°C.

En outre, le procédé tel que décrit ci-dessus permet d'éliminer une étape de gravure par voie chimique et peut être utilisé dans un process plasma en continu.

Selon une variante, on prévoit également de combiner un procédé de texturation, par exemple par voie chimique humide, pour obtenir des pyramides micrométriques avec le procédé décrit ci-dessus. On produit ainsi une texturation micrométrique par voie chimique combinée à une texturation nanométrique par voie plasma, c'est la texturation multi-échelle permettant d'obtenir les structures binaires ou combinées.

A cet effet, avant ladite étape d'exposition au plasma haute densité d'Ar ou du mélange d'Ar et de H₂, on réalise une étape de texturation permettant de réaliser ces pyramides micrométriques.

On peut par exemple utiliser une étape de texturation par voie humide telles que cités en introduction ou celle décrite dans le document WO2011/02 3894.

La courbe 3 montre les spectres de réflectivité des structures binaires ou combinés. Dans ce cas, on améliore en particulier la baisse de réflectivité dans la région du rouge par rapport à celle d'une texturation plasma d'Ar ou d'un mélange d'Ar et de H₂ haute densité seule.

Par rapport à une plaquette (« wafer » en anglais) polie, cette combinaison d'étapes de texturation permet d'obtenir une baisse de la réflectivité de 88,7% dans la région du bleu (effet du traitement plasma), c'est-à-dire les longueurs d'ondes inférieures à 500nm et de 65% dans la région du rouge (effet du traitement chimique), c'est-à-dire des longueurs d'ondes supérieures à 500nm.

L'invention a également pour objet un dispositif photovoltaïque, comprenant un substrat structuré présentant une surface texturée comme décrit ci-dessus, c'est-à-dire avec des structures unitaires ou binaires comme décrit ci-dessus présentant des structures en plans enroulés.

Il peut s'agir d'un dispositif photovoltaïque en couches minces, ou d'un dispositif photovoltaïque en silicium mono - cristallin, notamment à hétérojonctions.

## Revendications

1. Procédé de texturation de la surface d'un substrat de silicium, **caractérisé en ce qu'**il comprend, à une température inférieure à 200°C, une phase d'exposition de ladite surface à un plasma d'Ar ou d'un mélange d'Ar et de H₂ de haute densité d'une puissance comprise entre 1.5 W/cm² et 6.5 W/cm², le flux d'argon étant supérieur à trois fois le flux d'hydrogène avec une polarisation RF du substrat comprise entre 100 V et 300V, en que la pression de travail est comprise entre 0,7 Pascal et 1,3 Pascal.

2. Procédé de texturation selon la revendication 1, **caractérisé en ce que** le plasma est un plasma choisi dans le groupe suivant :
- un plasma haute densité de type résonance cyclotronique électronique distribuée en matrice (MDECR),
- un plasma haute densité généré par couplage inductif (ICP),
- un plasma par couplage inductif résonant, également dénommé plasma Helicon,
- un plasma thermique expansif ETP.

3. Procédé de texturation selon l'une quelconque des revendications 1 à 2, **caractérisé en ce que** le temps d'exposition de la surface au plasma d'Ar ou d'un mélange d'Ar et de H₂ de haute densité est supérieur à 1 minute, notamment compris entre 1 et 30 minutes.

4. Procédé de texturation selon l'une quelconque des revendications 1 à 3, **caractérisé en ce qu'**avant ladite étape d'exposition au plasma d'Ar ou d'un mélange d'Ar et de H₂ de haute densité, on réalise une étape de texturation micrométrique par voie chimique permettant d'obtenir des pyramides micrométriques.

5. Substrat de silicium structuré, **caractérisé en ce que** la structuration est en forme de plans enroulés, dits structures enroulées unitaires, lesdits plans enroulés correspondant à des murets sensiblement verticaux séparés par des sillons et évoluant sur la surface du substrat de façon courbe, sur la surface de silicium.

6. Substrat de silicium structuré selon la revendication 5, **caractérisé en ce que** le plan enroulé présente environ 200nm de hauteur et 20 nm d'épaisseur.

7. Substrat de silicium structuré selon la revendication 6, **caractérisé en ce que** le diamètre moyen extérieur des structures enroulées unitaires est compris entre 150nm et 250nm, lesdites structures enroulées unitaires correspondant à un ensemble de plans enroulés autour d'un même centre.

8. Substrat de silicium structuré selon l'une quelconque des revendications 5 à 7 **caractérisé en ce que** la structuration en forme de plans enroulés est réalisée sur des pyramides micrométriques, et **en ce que** le diamètre extérieur et la hauteur moyens d'une structure binaire, correspondant à des structures en plans enroulés nanométriques qui se greffent sur le motif initial de gravure des pyramides micrométriques, est équivalent à ceux des pyramides.

9. Dispositif photovoltaïque, **caractérisé en ce qu'**il comprend un substrat de silicium structuré à surface texturé selon l'une quelconque des revendications 5 à 8.

10. Dispositif photovoltaïque selon la revendication 9, **caractérisé en ce qu'**il s'agit d'un dispositif photovoltaïque en couches minces ou d'un dispositif photovoltaïque en silicium mono - cristallin, notamment un dispositif photovoltaïque à hétérojonctions.

## Patentansprüche

1. Verfahren zur Texturierung der Oberfläche eines Siliciumsubstrats, **dadurch gekennzeichnet, dass** es, bei einer Temperatur von weniger als 200 °C, eine Expositionsphase umfasst, in welcher ein Plasma von hoher Dichte aus Ar oder aus einer Mischung von Ar und H₂ mit einem Leistungswert im Bereich von 1,5 W/cm² bis 6,5 W/cm² auf die Oberfläche einwirkt, wobei der Argonfluss mehr als dem Dreifachen des Wasserstoffflusses entspricht und das Substrat eine RF-Polarisierung im Bereich von 100 V bis 300 V erfährt, und dass der Arbeitsdruck im Bereich von 0,7 Pascal bis 1,3 Pascal liegt.

2. Verfahren zur Texturierung nach Anspruch 1, **dadurch gekennzeichnet, dass** es sich bei dem Plasma um ein Plasma handelt, das aus der folgenden Gruppe ausgewählt ist:
- einem Plasma von hoher Dichte des Typs matrixverteilte Elektronensynchrotonresonanz (MDECR),
- einem Plasma von hoher Dichte, das mittels induktiver Kopplung erzeugt wird (ICP),
- einem Plasma mittels resonanzbasierter induktiver Kopplung, welches auch als Helikonplasma bezeichnet wird,
- einem sich ausdehnenden thermischen Plasma ETP.

3. Verfahren zur Texturierung nach einem beliebigen der Ansprüche 1 bis 2, **dadurch gekennzeichnet, dass** die Expositionszeitdauer, während der ein Plasma von hoher Dichte aus Ar oder einer Mischung von Ar und H₂ auf die Oberfläche einwirkt, mehr als 1 Minute beträgt und insbesondere im Bereich von 1 bis 30 Minuten liegt.

4. Verfahren zur Texturierung nach einem beliebigen der Ansprüche 1 bis 3, **dadurch gekennzeichnet, dass** vor dem Schritt, in welchem das Plasma von hoher Dichte aus Ar oder einer Mischung von Ar und H₂ einwirkt, ein Schritt der Texturierung im Mikrometermaßstab auf chemischem Wege durchgeführt wird, mittels dessen Pyramiden im Mikrometermaßstab erhalten werden können.

5. Strukturiertes Siliciumsubstrat, **dadurch gekennzeichnet, dass** die Strukturierung in Form aufgerollter Ebenen vorliegt, die als aufgerollte Struktureinheiten bezeichnet werden, wobei die aufgerollten Ebenen im Wesentlichen vertikalen Graten entsprechen, die durch Furchen voneinander getrennt sind und auf der Oberfläche des Substrats einen gekrümmten Verlauf zeigen, auf der Siliciumoberfläche.

6. Strukturiertes Siliciumsubstrat nach Anspruch 5, **dadurch gekennzeichnet, dass** die aufgerollte Oberfläche ungefähr eine Höhe von 200 nm und eine Dicke von 20 nm aufweist.

7. Strukturiertes Siliciumsubstrat nach Anspruch 6, **dadurch gekennzeichnet, dass** der mittlere Außendurchmesser der aufgerollten Struktureinheiten im Bereich zwischen 150 nm und 250 nm liegt, wobei die aufgerollten Struktureinheiten einer Gesamtheit von Ebenen entsprechen, welche um ein und denselben Mittelpunkt aufgerollt sind.

8. Strukturiertes Siliciumsubstrat nach einem beliebigen der Ansprüche 5 bis 7, **dadurch gekennzeichnet, dass** die Strukturierung in Form aufgerollter Ebenen auf den Pyramiden im Mikrometermaßstab vorgenommen wird, und dadurch, dass die Mittelwerte des Außendurchmessers und der Höhe einer binären Struktur, welche den Strukturen aus aufgerollten Ebenen im Nanometermaßstab entspricht, nachdem diese auf dem ursprünglichen Ätzmotiv der Pyramiden im Mikrometermaßstab angeordnet wurden, denjenigen der Pyramiden gleichwertig sind.

9. Photovoltaische Vorrichtung, **dadurch gekennzeichnet, dass** sie ein strukturiertes Siliciumsubstrat mit einer texturierten Oberfläche nach einem beliebigen der Ansprüche 5 bis 8 umfasst.

10. Photovoltaische Vorrichtung nach Anspruch 9, **dadurch gekennzeichnet, dass** es sich um eine photovoltaische Vorrichtung aus Dünnschichten oder um eine photovoltaische Vorrichtung aus monokristallinem Silicium, insbesondere eine photovoltaische Vorrichtung mit Heteroübergängen, handelt.

## Claims

1. Method for texturing the surface of a silicon substrate, **characterized in that** it comprises, at a temperature below 200°C, a phase of exposing said surface to a high-density plasma of Ar or of a mixture of Ar and H₂ with a power between 1.5 W/cm² and 6.5 W/cm², the flow of argon being three times higher than the flow of hydrogen with an RF biasing of the substrate between 100 V and 300 V, and **in that** the working pressure is between 0.7 pascal and 1.3 pascals.

2. Texturing method according to Claim 1, **characterized in that** the plasma is a plasma chosen from the following group:
- a high-density matrix-distributed electron cyclotron resonance (MDECR) plasma;
- a high-density inductively coupled plasma (ICP);
- a resonant inductively coupled plasma, also referred to as a helicon plasma;
- an expanding thermal plasma (ETP).

3. Texturing method according to either of Claims 1 and 2, **characterized in that** the time for which the surface is exposed to the high-density plasma of Ar or of a mixture of Ar and H₂ is longer than one minute, in particular between one and 30 minutes.

4. Texturing method according to any one of Claims 1 to 3, **characterized in that** before said step of exposure to the high-density plasma of Ar or of a mixture of Ar and H₂, a step of chemical micrometre-scale texturing is carried out, allowing micrometre-scale pyramids to be obtained.

5. Structured silicon substrate, **characterized in that** the structuring is in the form of rolled-up planes, referred to as unitary rolled-up structures, said rolled-up planes corresponding to substantially vertical walls that are separated by furrows and cover the surface of the substrate in curves over the silicon surface.

6. Structured silicon substrate according to Claim 5, **characterized in that** the rolled-up plane is about 200 nm in height and 20 nm in thickness.

7. Structured silicon substrate according to Claim 6, **characterized in that** the average outside diameter of the unitary rolled-up structures is between 150 nm and 250 nm, said unitary rolled-up structures corresponding to a set of planes rolled up around one and the same centre.

8. Structured silicon substrate according to any one of Claims 5 to 7, **characterized in that** the structuring in the form of rolled-up planes is formed on micrometre-scale pyramids, and **in that** the average outside diameter and average height of a binary structure, corresponding to nanometrescale rolled-up plane structures which are grafted onto the initial etch pattern of the micrometre-scale pyramids, is equivalent to those of the pyramids.

9. Photovoltaic device, **characterized in that** it comprises a structured silicon substrate with a textured surface according to any one of Claims 5 to 8.

10. Photovoltaic device according to Claim 9, **characterized in that** it is a thin-film photovoltaic device or a monocrystalline-silicon photovoltaic device, in particular a heterojunction photovoltaic device.
